# FASCICULE DE BREVET EUROPEEN

(11) **EP 2 867 920 B1**
(45) Date de publication et mention de la délivrance du brevet: **25.07.2018**
(21) Numéro de dépôt: 13730901.9
(22) Date de dépôt: 25.06.2013
(51) Int. Cl.: H01L 21/768, B82Y 10/00, H01L 21/84, H01L 23/498

(54) **PROCEDE DE FABRICATION D'UNE STRUCTURE D'ACCUEIL POUR CONNECTER ELECTRIQUEMENT UN NANO-OBJET SUR UNE FACE DE CELLE-CI ET EN REPRENDRE LE CONTACT ELECTRIQUE SUR LA FACE OPPOSEE**
VERFAHREN ZUR HERSTELLUNG EINER AUFNAHMESTRUKTUR ZUR ELEKTRISCHEN VERBINDUNG EINES NANOOBJEKTS AUF EINER FLÄCHE DAVON UND NEUHERSTELLUNG EINES ELEKTRISCHEN KONTAKTS MIT DEM NANOOBJEKT AUF DER GEGENÜBERLIEGENDEN OBERFLÄCHE
METHOD FOR MANUFACTURING A RECEIVING STRUCTURE FOR ELECTRICALLY CONNECTING A NANO-OBJECT ON A SURFACE THEREOF AND RE- ESTABLISH ELECTRICAL CONTACT WITH THE NANO-OBJECT ON THE OPPOSITE SURFACE

(30) Priorité: 27.06.2012 FR 1256111
(43) Date de publication de la demande: 06.05.2015
(73) Titulaire: Commissariat à l'Énergie Atomique et aux Énergies Alternatives, 75015 Paris (FR)
(72) Inventeur: BAILLIN, Xavier, F-38920 Crolles (FR); LEDUC, Patrick, F-38000 Grenoble (FR)
(74) Mandataire: Brevalex
(86) Numéro de dépôt international: PCT/EP2013/063204
(87) Numéro de publication internationale: WO 2014/001290

(56) Documents cités:
- WO-A1-2009/022982
- US-A1- 2004 219 731
- US-A1- 2006 046 345
- US-A1- 2010 252 824
- LWIN MA ET AL: "Silicon on insulator nanoscale backside interconnects for atomic and molecular scale circuits", JOURNAL OF VACUUM SCIENCE AND TECHNOLOGY: PART B, AVS / AIP, MELVILLE, NEW YORK, NY, US, vol. 28, no. 5, 2 septembre 2010 (2010-09-02), pages 978-984, XP012144265, ISSN: 1071-1023, DOI: 10.1116/1.3484248

## Description

### DOMAINE TECHNIQUE

La présente invention concerne un procédé de fabrication d'une structure d'accueil pour connecter électriquement un nano-objet sur une face de celle-ci et en reprendre le contact électrique sur la face opposée.

Par « nano-objets », on entend des objets dont au moins l'une des dimensions se situe dans l'intervalle allant d'environ 1 nm à 100 nm. Et, dans cette catégorie des nano-objets, on inclut les nanoparticules (organiques ou inorganiques), les nanotubes, les nanofils, les molécules et les associations de molécules, en particulier les molécules biologiques telles que les virus et les bactéries « de petite taille » par exemple.

L'invention trouve des applications notamment en électronique, en optique, en chimie et en biologie. En particulier, elle permet de produire des boîtiers de caractérisation moléculaire.

### ÉTAT DE LA TECHNIQUE ANTÉRIEURE

Pour déterminer au moins la fonctionnalité électrique d'un nano-objet, il est nécessaire de le poser, de le greffer ou de l'hybrider sur un support équipé de connecteurs électriques. La rugosité de ces derniers doit être de l'ordre de l'échelle atomique, c'est-à-dire de l'ordre de 0,1 nm. Compte tenu des dimensions de ces connecteurs électriques, la distance entre ceux-ci doit être aussi proche que possible de la taille du nano-objet.

De plus, en vue d'une intégration collective, il est préférable d'utiliser un substrat en silicium, compte tenu des technologies collectives qui ont été développées dans le cadre de l'industrie de la microélectronique.

Actuellement, il n'existe aucune solution technologique simple pour hybrider collectivement des nano-objets sur une tranche de silicium (en anglais, *silicon wafer*) ayant une surface dont la rugosité est parfaitement contrôlée.

Une technique d'hybridation est divulguée par le document suivant auquel on se reportera :

### [1] WO 2009/022982, Nano-interconnects for atomic and molecular scale circuits.

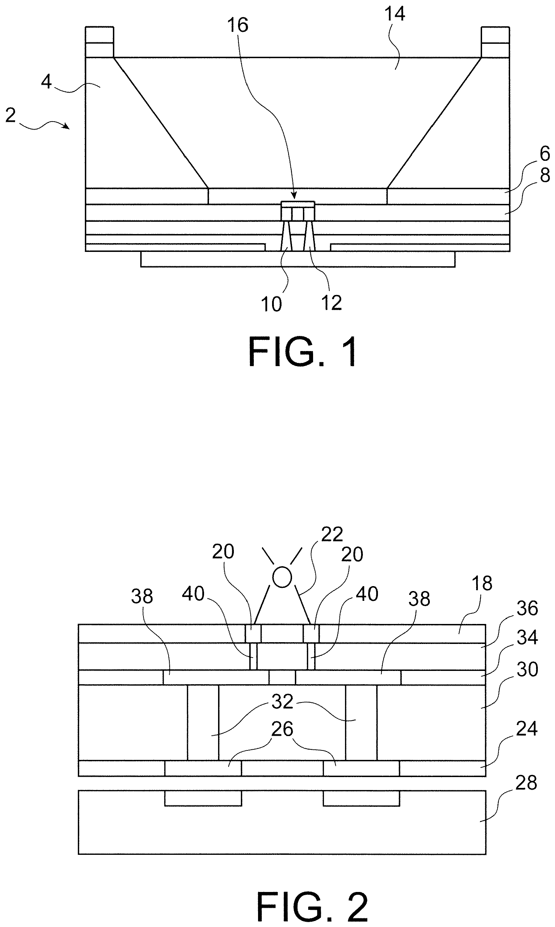

Cette technique est illustrée par la figure 1 des dessins annexés, qui est une vue en coupe schématique d'un support équipé d'interconnexions de taille nanométrique. Cette technique utilise un substrat 2 de type SOI (« pour « *Silicon On Insulator* »), comportant une couche épaisse de silicium 4, une couche d'oxyde enterré (en anglais, *buried oxide*) 6, plus simplement appelée BOX, et une couche mince de silicium 8.

Des nanovias 10 et 12 sont usinés depuis la face inférieure du substrat. Ils débouchent sur une face interne, située au fond d'une cavité 14, où sera placé le nano-objet 16 à connecter.

La réalisation des connecteurs électriques traversants, constitués par les nanovias, appelés aussi TSV (pour Through Silicon Via), nécessite l'emploi d'un outil spécifique, à savoir un FIB, ou faisceau d'ions focalisé (en anglais, *focused ion beam*), pour l'usinage localisé des nanovias. Non seulement le diamètre mais aussi la profondeur de ceux-ci vont être limités par la technique utilisée.

La technique divulguée par le document [1] ne peut pas utiliser le procédé collectif de photolithographie et gravure. De plus, les nanovias traversants sont inclinés afin de réduire leur espacement. On complique ainsi davantage l'usinage puisqu'il faut contrôler précisément l'angle d'inclinaison du faisceau d'ions par rapport au plan du substrat.

Une autre technique est divulguée par le document suivant :

### [2] Demande de brevet français n° 1061128, déposée le 23 décembre 2010, Dispositif pour connecter des nano-objets à des systèmes électriques externes, et procédé de fabrication du dispositif.

Cette autre technique est illustrée par la figure 2 des dessins annexés, qui est une vue en coupe schématique d'un exemple du dispositif divulgué par le document [2].

Le dispositif de la figure 2 comprend :
- une couche supérieure 18 pourvue de plots de contact supérieurs 20 à connecter à un nano-objet 22,
- une couche inférieure 24 pourvue de plots de contact inférieurs 26 à connecter à un système électrique externe 28,
- une couche de liaison 30 comprenant des vias électriques traversants 32 en contact avec les plots inférieurs, et
- entre la couche de liaison et la couche supérieure, au moins deux couches 34, 36 pourvues de lignes conductrices 38 et de vias électriques 40, pour relier les plots supérieurs aux plots inférieurs.

Cette autre technique est également difficile à mettre en oeuvre.

### EXPOSÉ DE L'INVENTION

La présente invention a pour but de remédier aux inconvénients précédents.

Elle propose un procédé de fabrication d'une structure qui est plus simple à mettre en oeuvre que ceux des structures divulguées par les documents [1] et [2], pour y connecter électriquement un ou plusieurs nano-objets.

On propose, en particulier, une structure d'accueil, également appelée « interposeur » (en anglais, *interposer*), faite à partir de silicium et destinée à accueillir un ou plusieurs nano-objets et à les relier de sa face avant, reconstruite à l'échelle atomique, jusqu'à sa face arrière, en utilisant uniquement des technologies de la microélectronique pour réaliser un épanouissement des contacts électriques entre ces deux faces.

Cette structure d'accueil utilise deux niveaux électriques sur un substrat de type SOI, l'un constitué de lignes rendues conductrices par dopage, l'autre de vias traversants, reliés aux lignes.

La présente invention concerne un procédé de fabrication d'une structure d'accueil destinée à connecter électriquement au moins un nano-objet sur une première face d'un support et en reprendre le contact électrique sur une deuxième face dudit support, comprennant les étapes :
- fournir un support ayant une première face et une seconde face opposée à la première face,
- former des vias à partir de la première face du support et déposer dans les vias un matériau électriquement conducteur, en vue de former au moins deux interconnexions, à savoir des première et deuxième interconnexions, traversant le support de la première face à la deuxième face, de sorte que la première face comprend des premières zones de reprise de contact et la deuxième face comprend des deuxièmes zones de reprise de contact pour les première et deuxième interconnexions,
- former des lignes conductrices rendues conductrices sur la première face du support par implantation de dopants, en vue de former, sur la première face, des premières zones de reprise de contact pour les première et deuxième interconnexions, chaque ligne conductrice ayant un motif qui s'étend, sur la première face du support, à partir de l'interconnexion qui lui est associée,
- effectuer un traitement thermique des zones dopées pour faire diffuser les dopants implantés.

Selon un mode de réalisation particulier de ce procédé, on amincit le support, ce qui permet de faire déboucher les vias sur la deuxième face du support.

De préférence, on forme en outre, sur la deuxième face du support, des couches électriquement conductrices qui sont respectivement associées aux vias, chacune des couches électriquement conductrices étant en contact avec le matériau électriquement conducteur du via qui lui est associé.

Selon un mode de réalisation préféré du procédé, objet de l'invention, chaque via a une géométrie tubulaire, à un tube ou plusieurs tubes coaxiaux.

De préférence, on reporte un capot, comportant une cavité, sur la première face du support.

Ce report est de préférence effectué sous atmosphère contrôlée.

Selon un mode de réalisation particulier, les interconnexions sont perpendiculaires aux première et deuxième faces.

Selon un mode de réalisation particulier, le support est une multicouche et comprend au moins une couche résistive au niveau de la première face du support, et dans laquelle les zones dopées sont formées dans la couche résistive, sur au moins une partie de l'épaisseur de celle-ci.

Selon un mode de réalisation particulier, le support est de type semi-conducteur sur isolant et comporte ainsi une couche superficielle semi-conductrice, et dans laquelle la couche résistive est constituée par la couche superficielle semi-conductrice.

Selon un mode de réalisation particulier, le support comprend une couche de silicium résistive, formée sur une couche de silice, elle-même formée sur un substrat de silicium, ou une couche de silicium résistive, formée sur une couche d'un isolant monocristallin, formant elle-même un substrat, par exemple une couche de saphir monocristallin.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- la figure 1 est une vue en coupe schématique d'un support équipé d'interconnexions, divulgué par le document [1], et a déjà été décrite,
- la figure 2 est une vue en coupe schématique d'un exemple du dispositif divulgué par le document [2], et a déjà été décrite,
- la figure 3 est une vue en coupe transversale schématique d'un exemple de la structure d'accueil, obtenue selon le procédé objet de l'invention,
- la figure 4 est une vue de dessus schématique de cet exemple,
- la figure 5 est une vue en coupe transversale schématique d'une variante de cet exemple,
- les figures 6 et 7 sont des vues de dessus schématiques d'autres variantes de cet exemple,
- la figure 8 est une vue en coupe transversale schématique de l'exemple illustré par la figure 3, complété par des connexions électriques sur sa face inférieure,
- la figure 9 est une vue de dessus schématique de l'exemple illustré par la figure 8,
- la figure 10 est une vue en coupe transversale schématique de l'exemple illustré par la figure 8 complété par un capot sur sa face supérieure, et
- les figures 11 à 13 sont des vues de dessus schématiques d'autres exemples de la structure d'accueil obtenue selon le procédé objet de l'invention.

### EXPOSÉ DÉTAILLÉ DE MODES DE RÉALISATION PARTICULIERS

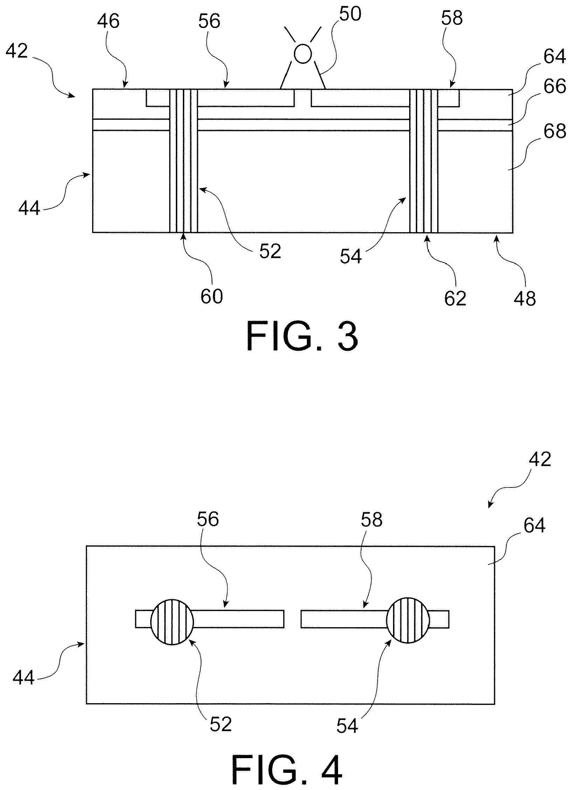

La figure 3 est une vue en coupe schématique d'une structure d'accueil, obtenue selon le procédé objet de l'invention. Et la figure 4 est une vue de dessus de ce mode de réalisation particulier.

Cette structure d'accueil, ou interposeur, a la référence 42 sur les figures 3 et 4. Elle est dotée de connexions électriques horizontales, reliées à des connexions électriques verticales.

Plus précisément, la structure d'accueil 42, représentée sur les figures 3 et 4, comprend un support 44 dont la face supérieure a la référence 46 et dont la face inférieure, opposée à la face supérieure, a la référence 48. Cette structure d'accueil 42 est prévue pour connecter électriquement un nano-objet 50 sur la face supérieure 46 et en reprendre le contact électrique sur la face inférieure 48.

La structure d'accueil 42 comprend aussi deux interconnexions 52 et 54 qui traversent le support 44 de la face supérieure 46 à la face inférieure 48.

Ces faces 46 et 48 comprennent respectivement des zones de reprise de contact pour chacune des interconnexions 52 et 54 : sur la face supérieure 46 (respectivement la face inférieure 48), les zones de reprise de contact associées aux interconnexions 52 et 54 ont respectivement les références 56 et 58 (respectivement 60 et 62).

Conformément à l'invention, les zones de reprise de contact 56 et 58 sont des zones dopées du support 44. Et chaque zone dopée 56 ou 58 a un motif adapté à l'épanouissement, sur la face supérieure 46 du support 44, de l'interconnexion 52 ou 54 qui lui est associée.

Dans l'exemple représenté, le support 44 est une multicouche de type semiconducteur sur isolant. Il comprend une couche de silicium résistive 64, formée sur une couche de silice 66, elle-même formée sur un substrat de silicium 68.

Les zones dopées 56 et 58 sont formées dans la couche de silicium résistive 64, sur une partie de l'épaisseur de celle-ci.

Les zones 56 et 58 sont dopées par implantation de dopants, tels que l'arsenic, le phosphore ou le bore par exemple, dans la couche 64, puis activation de ces dopants. Ces zones 56 et 58 sont reliées à des vias verticaux qui constituent les interconnexions 52 et 54 et sont en polysilicium dopé au moyen de phosphore ou de bore par exemple.

Ainsi, les interconnexions 52 et 54 sont avantageusement verticales ou, plus précisément, perpendiculaires à la face inférieure 48 et à la face supérieure 46 du support 44.

Dans une variante, les vias verticaux peuvent être faits en tungstène que l'on dépose par exemple par CVD c'est-à-dire par dépôt chimique en phase vapeur (en anglais, *chemical vapor deposition*)*.*

Comme on l'a vu, les zones dopées 56 et 58 sont réalisées dans la partie supérieure du support ou substrat 44 ; et ce dernier est un SOI composé de la couche 68 (silicium de quelques centaines de micromètres d'épaisseur), de la couche 66 (BOX de quelques centaines de nanomètres à quelques micromètres d'épaisseur), et de la couche 64 (silicium dont l'épaisseur est de l'ordre de quelques centaines de nanomètres à quelques dizaines de micromètres).

Les deux couches de silicium 64 et 68 utilisées dans ce cas sont faite de silicium de haute résistivité, typiquement de l'ordre de 10³ ohm.cm à 5x10³ ohm.cm, afin de garder une isolation électrique entre les différentes zones dopées.

Pour la couche 68, on peut envisager un autre matériau que du silicium, par exemple un verre ou une céramique qui sera électriquement isolant mais devra être gravé de façon anisotrope pour pouvoir réaliser les TSV constitués par les vias verticaux.

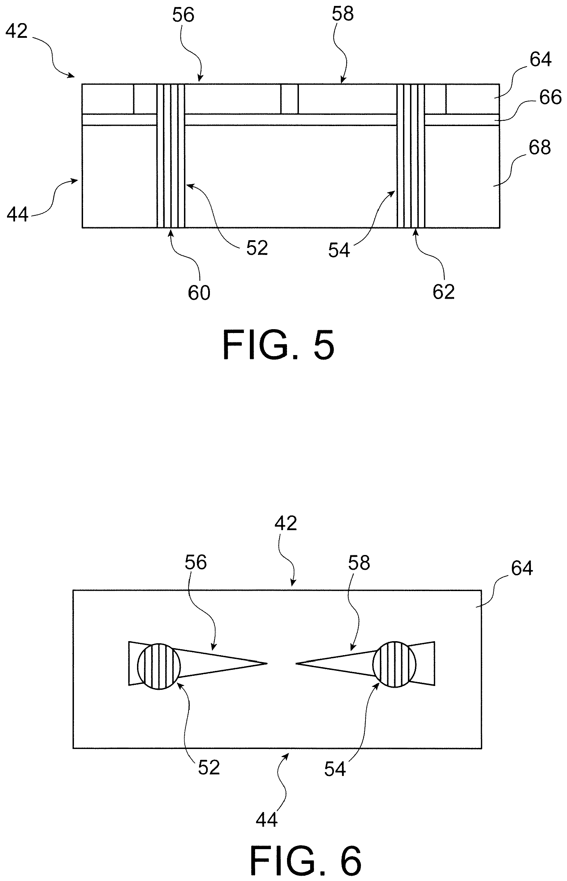

La figure 5 est une vue en coupe schématique d'une variante de la structure d'accueil 42 de la figure 3 : dans l'exemple de la figure 5, les zones dopées sont formées dans la couche de silicium 64, sur toute l'épaisseur de celle-ci, et s'arrêtent donc sur la couche d'oxyde 66 (BOX).

Diverses géométries sont possibles pour la définition des zones dopées 56 et 58. Ceci est illustré par la figure 6 qui est une vue de dessus schématique d'une variante de la structure d'accueil 42 de la figure 4. Comme on le voit sur la figure 6, les zones dopées 56 et 58 peuvent avoir une forme de pointe (d'où deux pointes en regard l'une de l'autre), alors que les zones dopées sont rectilignes sur la figure 4.

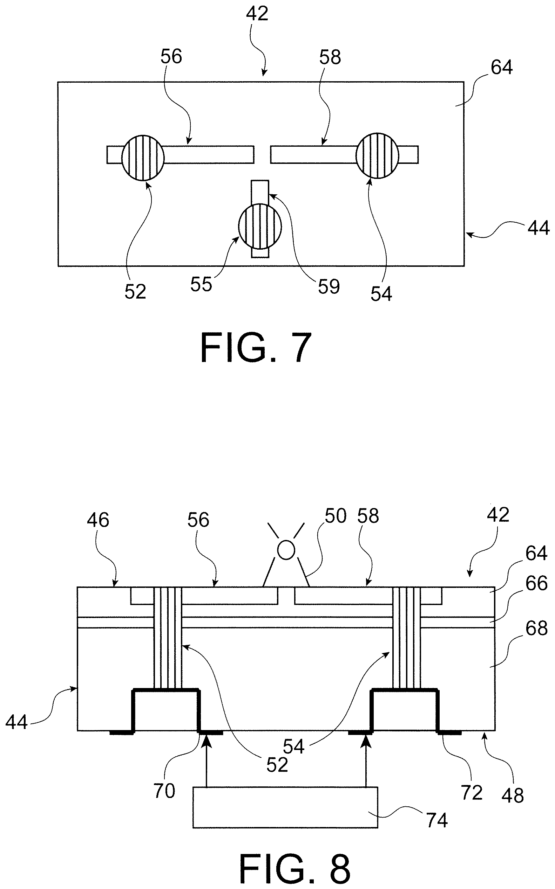

Dans certains cas, le nano-objet étudié peut nécessiter plus de deux connexions électriques. Ceci est illustré par la figure 7 qui est une vue de dessus schématique d'une variante de la structure d'accueil de la figure 4.

Comme on le voit sur la figure 7, le nano-objet peut, par exemple, nécessiter trois connexions. Et la structure d'accueil comporte alors trois zones dopées, à savoir les zones 56 et 58 et une zone dopée supplémentaire 59, qui est faite de silicium monocristallin comme les zones 56 et 58. Une interconnexion supplémentaire 55, associée à la zone 59, est alors nécessaire, en plus des interconnexions 52 et 54 qui sont respectivement associées aux zones 56 et 58.

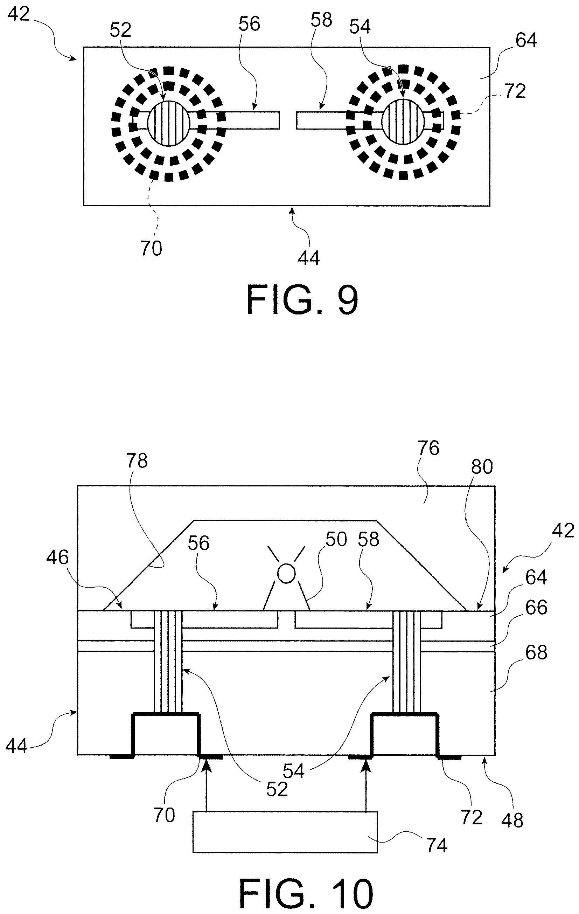

La figure 8 est une vue en coupe transversale schématique d'un autre exemple de l'invention. Et la figure 9 est une vue de dessus de cet autre exemple.

Comme on le voit, cet autre exemple diffère de celui qui est représenté sur les figures 3 et 4 : à l'exemple des figures 3 et 4 on a ajouté des connexions électriques 70 et 72 qui débouchent sur la face arrière 48 de la structure d'accueil 42 et sont respectivement en contact avec les interconnexions 52 et 54.

En fait, conformément à un procédé de fabrication dont il sera question par la suite, les interconnexions des figures 8 et 9 ne débouchent pas initialement sur la face arrière 48; et l'on grave la couche 68 par cette face arrière 48 pour atteindre les interconnexions. Ensuite, on forme les connexions électriques 70 et 72 de façon qu'elles soient en contact avec les interconnexions.

Les connexions électriques 70 et 72 permettent, par exemple, de connecter le nano-objet 50 à un système électrique externe approprié 74, par l'intermédiaire des interconnexions 52 et 56, en vue d'effectuer des mesures électriques sur le nano-objet 50.

La figure 10 illustre schématiquement le fait qu'une structure d'accueil fabriquée selon un procédé de fabrication conforme à l'invention peut comprendre un capot 76 comportant une cavité 78, adaptée pour enfermer le nano-objet 50 qui est électriquement connecté aux zones dopées 56 et 58.

Dans l'exemple représenté, on a reporté le capot 76 sur la structure d'accueil 42 que l'on a décrite en faisant référence à la figure 8. Comme on le voit, le capot 76 est collé au substrat SOI 44 de la structure 42 par l'intermédiaire d'une zone de collage 80 qui s'étend sur la face supérieure 46 du substrat 44 et entoure l'ensemble des zones dopées 56 et 58.

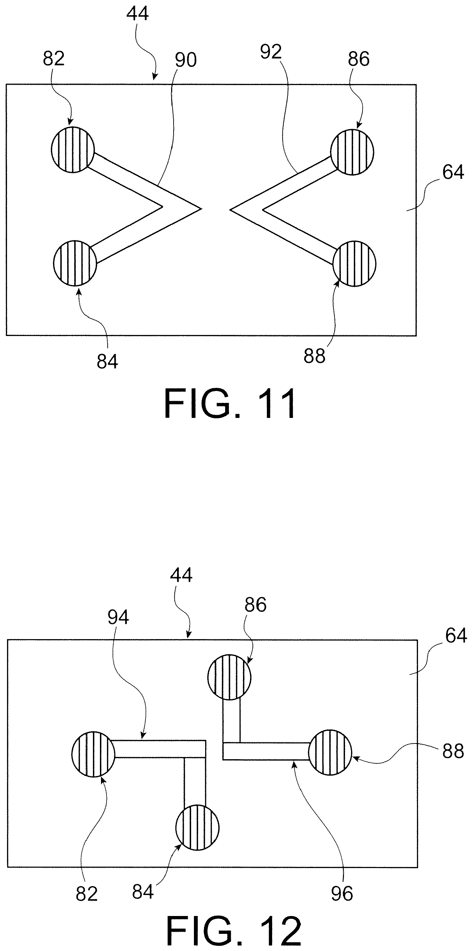

Les figures 11 à 13 sont des vues de dessus schématiques de structures d'accueil qui sont conformes à l'invention et constituent des structures pour tester des nano-objets.

Les exemples des figures 11 et 12 sont des structures de test à quatre plots. Dans ce cas, comme on le voit, le substrat 44 est pourvu de quatre interconnexions 82, 84, 86 et 88 (au lieu de deux ou trois dans les exemples précédents). Et deux zones dopées 90 et 92 (figure 11) ou 94 et 96 (figure 12) sont prévues dans la couche de silicium 64.

Comme on le voit, dans le cas de la figure 11, les zones 90 et 92 forment des V dont les pointes sont en regard l'une de l'autre. Les extrémités de la zone 90 sont respectivement connectées aux interconnexions 82 et 84 tandis que les extrémités de la zone 92 sont respectivement connectées aux interconnexions 86 et 88.

Dans le cas de la figure 12, comme on le voit, les extrémités de la zone 94 sont respectivement connectées aux interconnexions 82 et 84 tandis que les extrémités de la zone 96 sont respectivement connectées aux interconnexions 86 et 88. Et, comme on le voit, chacune des zones 94 et 96 est en deux parties rectilignes qui sont orthogonales l'une à l'autre. Et deux parties respectives des zones 94 et 96 sont alignées (et espacées l'une de l'autre).

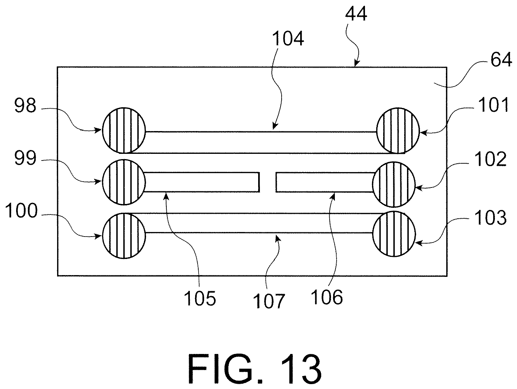

L'exemple de la figure 13 est une structure de test à trois ports pourvus d'une masse (en anglais, *ground*) coplanaire. Dans ce cas, comme on le voit, le substrat 44 est pourvu de deux groupes de trois interconnexions en vis-à-vis 98, 99, 100 et 101, 102, 103.

Quatre zones dopées rectilignes et parallèles 104, 105, 106, 107 sont prévues : comme on le voit, la zone 104 relie les interconnexions 98 et 101 ; la zone 107 relie les interconnexions 100 et 103 ; et les zones 105 et 106 sont respectivement reliées aux interconnexions 99 et 102 et sont dans le prolongement l'une de l'autre mais espacées l'une de l'autre, et sont comprises entre les zones 104 et 107.

On expose ci-après divers avantages qui sont liés à la structure d'accueil.
1- La structure d'accueil 42 peut être réalisée uniquement en silicium, oxyde de silicium et dopants classiques (de type N ou P) du silicium. Dans une variante, on peut utiliser un substrat 42 composé d'une première couche de silicium monocristallin de haute résistivité (correspondant à la couche 64) sous laquelle est disposée une couche d'un isolant monocristallin, par exemple une couche de saphir monocristallin. Cette dernière couche remplace alors les couches 66 et 68.
2- La structure d'accueil 42 peut être portée à une température qui est compatible avec une reconstruction atomique de la surface extérieure de la couche 64, typiquement une température de l'ordre de 1100°C.
3- Les lignes de connexion dessinées par dopage (zones dopées) ne perturbent pas la reconstruction de surface nécessaire au dépôt de nano-objets tels que des molécules.
4- Le dessin des zones dopées et le contrôle de la diffusion des dopants est prévu pour rapprocher les zones dopées à une distance de quelques nanomètres à quelques dizaines de nanomètres l'une de l'autre. A titre de d'exemple, pour un coefficient de diffusion de 10⁻¹¹cm²/s, un traitement thermique de 10 minutes à 1100°C provoque une diffusion sur une distance de 1550nm. Pour des coefficients de diffusion de 10⁻¹²cm²/s et 10⁻¹³cm²/s on obtient respectivement 490 nm et 155 nm. Il est donc nécessaire d'écarter les extrémités des zones implantées d'au moins deux fois la distance de diffusion si l'on veut finalement obtenir des zones conductrices électriques qui sont distantes l'une de l'autre de quelques nanomètres. Ces dimensions sont compatibles avec les outils de photolithographie qui permettent de définir les zones à implanter. Dans une variante, on peut envisager de doper les zones 56 et 58 par des dopants de natures chimiques différentes (même type de dopage P ou N pour les deux zones, ou dopage P pour une zone et N pour l'autre).
5- Le dessin de chaque zone à implanter peut être défini selon diverses géométries et de façon à contrôler au mieux le profil de diffusion des dopants.
6- Les vias descendants, également appelés « vias verticaux » dans les exemples précédemment décrits, sont de préférence éloignés de plusieurs micromètres à plusieurs centaines de micromètres, de la zone située entre les extrémités des zones dopées, c'est-à-dire de la zone dont la surface sera reconstruite à l'échelle atomique. Ils ne perturbent donc pas la reconstruction de cette zone.
7- La reconstruction de la surface supérieure 46 permet de rapporter un capot 76 en silicium par collage moléculaire silicium sur silicium.
8- Des vias débouchant sur la face arrière 48 de la structure d'accueil 42 peuvent être obtenus selon un procédé classique de réalisation de TSV (pour « Through Silicon Via »).

On donne ci-après les étapes d'un procédé de fabrication d'une structure d'accueil conforme à l'invention.
1- Dans un substrat SOI 44, on forme des vias descendants selon un procédé de photolithographie et de gravure profonde du silicium (DRIE pour « Deep Reactive Ion Etching »). Les vias sont avantageusement définis selon une géométrie de tube dont l'épaisseur vaut environ quelques micromètres. Afin de réduire la résistance électrique de chaque via descendant, il est possible de former plusieurs tubes coaxiaux, par exemple trois, au lieu d'un seul tube ; on forme initialement, par exemple, un tube de 10 µm de diamètre, et l'on entoure ce tube de deux autres tubes dont les diamètres valent respectivement 30 µm et 50 µm.
2- On remplit les vias verticaux (vias descendants) par dépôt chimique en phase vapeur (CVD) de silicium polycristallin dopé. En variante, on peut les remplir de tungstène que l'on dépose encore par CVD, ou plus généralement de tout métal réfractaire, compatible avec le traitement thermique dont il est question à l'étape 8 décrite par la suite.
3- On effectue un polissage mécano-chimique (CMP) pour retirer le silicium qui a été déposé sur les surfaces du substrat.
4- On dépose un masque d'implantation qui est par exemple en oxyde de silicium ou en nitrure de silicium et dont l'épaisseur est de l'ordre de 1 µm ou moins, suivant la résolution recherchée et la dose à implanter.
5- On effectue une photolithographie et une gravure du masque.
6- On effectue l'implantation des dopants.
7- On procède au retrait du masque.
8- On effectue un traitement thermique à une température de l'ordre de 1100°C pendant quelques minutes afin, simultanément, de reconstruire la surface et de faire diffuser les dopants. Cette température est donnée à titre d'exemple : on peut envisager des températures plus basses, comprises entre environ 900°C et 1100°C.
9- On effectue un traitement du capot (référence 76 sur la figure 10) selon le même procédé que celui dont il est question à l'étape 8 et l'on assemble le capot au substrat afin de préserver la surface reconstruite. Avantageusement, l'opération d'assemblage est effectuée sous atmosphère contrôlée, par exemple une atmosphère d'azote ou d'un gaz inerte tel que l'argon.
10- On amincit la face arrière de l'assemblage ainsi obtenue.
11- On effectue une photolithographie et une gravure du silicium, à partir de cette face arrière, jusqu'à ce que l'on débouche sur les vias descendants préalablement formés.
12- On dépose des couches métalliques (couches 70 et 72 de la figure 10) pour ramener le contact électrique depuis le fond de chaque via jusqu'à la face arrière de l'assemblage obtenu.

Dans une variante de ce procédé, l'amincissement (étape 10) peut être effectué jusqu'à ce que l'on débouche sur les vias descendants. Dans ce cas, l'étape 11 n'est pas nécessaire.

Selon une alternative du procédé de fabrication, on modifie l'ordre des étapes 1 à 11 ci-dessus : on effectue d'abord les étapes 4, 5, 6, 7 puis les étapes 1, 2, 3, puis les étapes 8, 9, 10 et 11.

Dans les exemples donnés plus haut, on a décrit des structures d'accueil comportant un seul nano-objet. Mais l'homme du métier peut bien entendu adapter les exemples donnés pour obtenir des structures d'accueil conformes à l'invention et comportant plusieurs nano-objets.

De plus, dans les exemples donnés, les zones dopées sont formées sur la face supérieure du substrat utilisé (face 46 du substrat 44 dans les exemples décrits). Mais on ne sortirait pas du cadre de l'invention en formant aussi, lorsqu'on le souhaite, des zones dopées sur la face inférieure de ce substrat (face 48 dans les exemples décrits). L'homme du métier peut adapter les exemples donnés plus haut à ce cas.

On a déjà mentionné plus haut divers domaines d'application de l'invention. On ajoutera que cette invention permet de réaliser collectivement des structures comportant un ou plusieurs nano-objet(s) encapsulé(s) de façon hermétique sous atmosphère contrôlée. Elle s'applique ainsi notamment à la fabrication de systèmes microélectroniques de type « Beyond CMOS ».

## Revendications

1. Procédé de fabrication d'une structure d'accueil (42) destinée à connecter électriquement au moins un nano-objet (50) sur une première face d'un support (44) et en reprendre le contact électrique sur une deuxième face dudit support, comprenant les étapes suivantes :
- fournir un support (44) ayant une première face (46) et une deuxième face (48) opposée à la première face,
- former des vias à partir de la première face du support (44) et déposer dans les vias un matériau électriquement conducteur, en vue de former au moins deux interconnexions (52, 54 ; 82, 84, 86, 88 ; 98, 99, 100, 101, 102, 103), à savoir des première et deuxième interconnexions, traversant le support de la première face à la deuxième face, de sorte que la première face comprend des premières zones de reprise de contact et la deuxième face comprend des deuxièmes zones de reprise de contact (56, 58, 60, 62, 90, 92, 94, 96, 104, 105, 106, 107) pour les première et deuxième interconnexions,
- former des lignes conductrices rendues conductrices sur la première face du support (56, 58, 90, 92, 94, 96, 104, 105, 106, 107) par implantation de dopants, en vue de former, sur la première face, des premières zones de reprise de contact pour les première et deuxième interconnexions, chaque ligne conductrice ayant un motif qui s'étend, sur la première face du support, à partir de l'interconnexion qui lui est associée,
- effectuer un traitement thermique des zones dopées pour faire diffuser les dopants implantés.

2. Procédé selon la revendication 1, dans lequel on amincit le support, ce qui permet de faire déboucher les vias sur la deuxième face du support.

3. Procédé selon la revendication 1 ou 2, dans lequel on forme en outre, sur la deuxième face (48) du support, des couches électriquement conductrices (70, 72) qui sont respectivement associées aux vias, chacune des couches électriquement conductrices étant en contact avec le matériau électriquement conducteur du via qui lui est associé.

4. Procédé selon l'une quelconque des revendications 1 à 3, dans lequel chaque via a une géométrie tubulaire, à un tube ou plusieurs tubes coaxiaux.

5. Procédé selon l'une quelconque des revendications 1 à 4, dans lequel on reporte un capot (76), comportant une cavité (78), sur la première face (46) du support, de préférence sous atmosphère contrôlée.

6. Procédé selon l'une des revendications 1 à 5, dans lequel les interconnexions sont perpendiculaires aux première et deuxième faces (46, 48).

7. Procédé selon l'une des revendications 1 à 5, dans lequel le support (44) est une multicouche et comprend au moins une couche résistive (64) au niveau de la première face (46) du support, et dans laquelle les zones dopées (56, 58) sont formées dans la couche résistive, sur au moins une partie de l'épaisseur de celle-ci.

8. Procédé selon la revendication 7, dans laquelle le support (44) est de type semi-conducteur sur isolant et comporte ainsi une couche superficielle semi-conductrice, et dans laquelle la couche résistive (64) est constituée par la couche superficielle semi-conductrice.

9. Procédé selon la revendication 8, dans lequel le support (44) comprend une couche de silicium résistive (64), formée sur une couche de silice (66), elle-même formée sur un substrat de silicium (68), ou une couche de silicium résistive, formée sur une couche d'un isolant monocristallin, formant elle-même un substrat, par exemple une couche de saphir monocristallin.

## Patentansprüche

1. Verfahren zur Herstellung einer Aufnahmestruktur (42), die dazu ausgelegt ist, wenigstens ein Nanoobjekt (50) elektrisch auf einer ersten Fläche eines Trägers (44) anzuschließen und seinen elektrischen Kontakt auf einer zweiten Fläche des Trägers wieder aufzunehmen, umfassend die folgenden Schritte:
- Bereitstellen eines Trägers (44) mit einer ersten Fläche (46) und einer zweiten Fläche (48), die zur ersten Fläche entgegengesetzt ist,
- Bilden von Durchführungen ausgehend von der ersten Fläche des Trägers (44), und Aufbringen eines elektrisch leitenden Materials in den Durchführungen, um wenigstens zwei Zwischenverbindungen (52,54; 82, 84, 86, 88; 98, 99, 100, 101, 102, 103) zu bilden, nämlich erste und zweite Zwischenverbindungen, die den Träger von der ersten Fläche zur zweiten Fläche durchsetzen, derart, dass die erste Fläche erste Kontaktnahmezonen umfasst, und die zweite Fläche zweite Kontaktnahmezonen (56, 58, 60, 62, 90, 92, 94, 96, 104, 105, 106, 107) umfasst, und zwar für die ersten und zweiten Zwischenverbindungen,
- Bilden von leitfähigen Leitungen, die durch Implantation von Dotierstoffen auf der ersten Fläche des Trägers (56, 58, 90, 92, 94, 96, 104, 105, 106, 107) leitfähig gemacht sind, um auf der ersten Fläche erste Kontaktnahmezonen für die ersten und zweiten Zwischenverbindungen zu bilden, wobei jede leitfähige Leitung ein Motiv hat, das sich auf der ersten Fläche des Trägers ausgehend von der Zwischenverbindung erstreckt, die ihr zugeordnet ist,
- Durchführen einer thermischen Behandlung der dotierten Zonen, um die implantierten Dotierstoffe diffundieren zu lassen.

2. Verfahren nach Anspruch 1, bei dem man den Träger abdünnt, was es erlaubt, die Durchführungen auf die zweite Fläche des Trägers münden zu lassen.

3. Verfahren nach Anspruch 1 oder 2, bei dem man ferner auf der zweiten Fläche (48) des Trägers elektrisch leitfähige Schichten (70,72) bildet, die jeweils den Durchführungen zugeordnet sind, wobei jede der elektrisch leitfähigen Schichten in Kontakt mit dem elektrisch leitfähigen Material der Durchführung ist, die ihr zugeordnet ist.

4. Verfahren nach einem der Ansprüche 1 bis 3, bei dem jede Durchführung eine röhrenförmige Geometrie mit einem Rohr oder mehreren koaxialen Rohren hat.

5. Verfahren nach einem der Ansprüche 1 bis 4, bei dem man einen Deckel (76), der einen Hohlraum (78) umfasst, auf der ersten Fläche (46) des Trägers aufbringt, vorzugsweise unter kontrollierter Atmosphäre.

6. Verfahren nach einem der Ansprüche 1 bis 5, bei dem die Zwischenverbindungen orthogonal zu der ersten und der zweiten Fläche (46, 48) sind.

7. Verfahren nach einem der Ansprüche 1 bis 5, bei dem der Träger (44) eine Mehrfachschicht ist und wenigstens eine Widerstandsschicht (64) im Bereich der ersten Fläche (46) des Trägers umfasst, und wobei die dotierten Zonen (56, 58) in der Widerstandsschicht wenigstens über einen Teil der Dicke derselben gebildet sind.

8. Verfahren nach Anspruch 7, bei dem der Träger (44) von Typ Halbleiter-auf-Isolator ist und somit eine halbleitende Oberflächenschicht umfasst, und bei dem die Widerstandsschicht (64) durch die halbleitende Oberflächenschicht gebildet ist.

9. Verfahren nach Anspruch 8, bei dem der Träger (44) eine Widerstandsschicht (64) aus Silizium umfasst, die auf einer Siliziumdioxidschicht (66) gebildet ist, die selbst wiederum auf einem Siliziumsubstrat (68) gebildet ist, oder eine Widerstandsschicht aus Silizium, die auf einer Schicht aus einem monokristallinen Isolator gebildet ist, die selbst ein Substrat bildet, beispielsweise eine Schicht aus monokristallinem Saphir.

## Claims

1. Method for manufacturing a receiving structure (42) for electrically connecting at least one nano-object (50) onto the first face and to re-establish electrical contact on the second face of said support, comprising the following steps:
- providing a support (44) having a first face (46) and a second face (48) opposite to the first face,
- forming vias from the first face of the support (44) and depositing an electrically conductive material in the vias, so as to form at least two interconnections (52, 54; 82, 84, 86, 88; 100, 101, 102, 103), namely first and second interconnections, crossing the support from the first face to the second face, so that the first face comprises first contact continuity zones and the second face comprises second contact continuity zones (56, 58, 60, 62, 90, 92, 94, 96, 104, 105, 106, 107) for the first and second interconnections,
- forming conductive lines made conductive on the first face of the support (56, 58, 90, 92, 94, 96, 104, 105, 106, 107) by implantation of doping agents, in view of forming, on the first face, first contact continuity zones for the first and second interconnections, each conductive line having a pattern which extends on the first face of the support from the interconnection that is associated with it,
- executing a heat treatment of the doped zones in order to diffuse the implanted doping agents.

2. Method according to claim 1, wherein the support is thinned so that the via scan open up on the second face of the support.

3. Method according to claim 1 or 2, wherein electrically conductive layers (70, 72) are also formed on the second face (48) of the support, which are respectively associated with the vias, each of the electrically conductive layers being in contact with electrically conductive material of the via that is associated with it.

4. Method according to one any of claims 1 to 3, wherein each via a tubular geometry, with a single tube or several coaxial tubes.

5. Method according to one any of claims 1 to 4, wherein a cover (76), comprising a cavity (78), is transferred onto the first face (46) of the support, preferably in a controlled atmosphere.

6. Method according to claims 1 to 5, wherein the interconnections are perpendicular to the first and second faces (46, 48).

7. Method according to claims 1 to 5, wherein the support (44) is a multilayer and comprises at least one resistive layer (64) at the first face (46) of the support, and in which the doped zones (56, 58) are formed in the resistive layer on at least part of its thickness.

8. Method according to claim 7, wherein the support (44) is a semiconductor on insulator type support and thus comprises a semiconducting surface layer, and in which the resistive layer (64) consists of the semiconducting surface layer.

9. Method according to claim 8, wherein the support (44) comprises a resistive silicon layer (64) formed on a silica layer (66), itself formed on a silicon substrate (68) or a resistive silicon layer, formed on a monocrystalline insulator layer itself forming a substrate, for example a monocrystalline sapphire layer.
